# EUROPEAN PATENT APPLICATION

(11) **EP 4 495 087 A1**
(43) Date of publication of application: **22.01.2025**
(21) Application number: 22932309.2
(22) Date of filing: 21.11.2022
(51) Int. Cl.: C04B 37/02, B23K 35/30, C22C 5/06, C22C 9/00

(54) **COPPER/CERAMIC BONDED SUBSTRATE AND PRODUCTION METHOD THEREFOR**

(30) Priority: 14.03.2022 JP 2022039744
(71) Applicant: Dowa Metaltech Co., Ltd., Tokyo 101-0021 (JP)
(72) Inventor: YUKI, Seiya, Tokyo 101-0021 (JP); TERAMOTO, Yuki, Tokyo 101-0021 (JP)
(74) Representative: Müller-Boré & Partner Patentanwälte PartG mbB
(86) International application number: PCT/JP2022/043043
(87) International publication number: WO 2023/176046

(57) **Abstract**

There is provided a copper-ceramic bonded substrate, including: a ceramic substrate; and a copper sheet bonded to at least one surface of the ceramic substrate, wherein the copper sheet has a Vickers hardness of 42.5 HV or less, and the copper sheet has a magnesium content of 1 ppm or less, a nickel content of 2.5 ppm or less, a tin content of 0.05 ppm or less, a selenium content of 0.3 ppm or less, a tellurium content of 0.07 ppm or less, and a bismuth content of 0.2 ppm or less.

## Description

### Technical field

The present invention relates to a copper-ceramic bonded substrate and a method for manufacturing the same.

### Description of related art

Power modules are used to control large amounts of power in electric vehicles, trains, machine tools, etc., and as an electric circuit board for such a power module, a metal-ceramic bonded substrate in which a metal circuit board such as Cu or Al is bonded to the surface of a ceramic plate is used. This metal-ceramic bonded substrate has a ceramic substrate having a circuit pattern metal sheet formed on one surface thereof, and a heat dissipating metal sheet formed on the other surface thereof.

As a method for manufacturing such a metal-ceramic bonded substrate, there is a method in which a brazing material made of a mixture of active metal, Ag, and Cu (Ag-Cu active metal brazing) material is interposed between a metal sheet and a ceramic plate by heat treatment (active metal brazing method) (see, for example, Patent Document 1).

Metal-ceramic bonded substrates for power modules are subjected to repeated heat loads during the assembly process of the power module and in the environment in which the power module is actually used.

For example, in a power module assembly process, a power semiconductor element is mounted on a circuit pattern metal sheet by a bonding method such as a solder bonding method or a fine particle metal sintering method, and a base plate made of Cu, Al, an Al-SiC composite material, etc., is bonded to the heat dissipating metal sheet by a similar bonding method. In this case, since the substrate is heated by passing through, for example, a tunnel (continuous) furnace, a bonded substrate is subjected to a heat load due to such a furnace passing process.

Further for example, in an actual use of a power module, power semiconductor elements generate heat during a switching operation, and are cooled when the power module stops operating, and therefore the power module is subjected to heat load due to heat cycles.

For example, Cu or Al is used for the circuit board of the metal-ceramic bonded substrate. When using aluminum, heat loads such as furnace processing and heat cycles are applied, and a thermal stress caused by a difference in thermal expansion between the ceramic substrate and the metal circuit board can be alleviated by a plastic deformation of the aluminum, but an Al metal circuit board is inferior to a Cu metal circuit board in terms of electrical conductivity and heat dissipation. On the other hand, when Cu is used as the metal circuit board, there is a problem that the reliability is inferior when a heat load is applied compared to when Al is used.

Therefore, the copper-ceramic bonded substrate is required to have good heat cycle properties that prevent the ceramic substrate from being damaged even when subjected to such a heat load.

As a method for alleviating the thermal stress in ceramic caused by heat load, a method of providing a stepped shape in a cross-sectional shape of a metal sheet bonded to a ceramic (see, for example, Patent Document 2), and a method of forming dimples on an outer periphery of a metal sheet bonded to a ceramic (for example, see Patent Document 3), are proposed.

### Prior art document

### Patent document

[Patent Document 1] JP 8-97554 A
[Patent Document 2] JP 10-125821 A
[Patent Document 3] JP 2012-114203 A

### Summary of the invention

### Problem to be solved by the invention

However, in the methods disclosed in Patent Documents 2 and 3, a mounting area for electronic components mounted on the surface of the metal sheet is reduced, which makes it necessary to increase an external size (area) of the copper-ceramic bonded substrate, resulting in an increase in the size of the power module.

Therefore, an object of the present invention is to provide a technique for realizing good heat cycle properties without changing an outer size of a copper-ceramic bonded substrate.

### Means for solving the problem

According to a first aspect of the present invention, there is provided a copper-ceramic bonded substrate, including:
a ceramic substrate; and
a copper sheet bonded to at least one surface of the ceramic substrate,
wherein the copper sheet has a Vickers hardness of 42.5 HV or less, and
the copper sheet has a magnesium content of 1 ppm or less, a nickel content of 2.5 ppm or less, a tin content of 0.05 ppm or less, a selenium content of 0.3 ppm or less, a tellurium content of 0.07 ppm or less, and a bismuth content of 0.2 ppm or less.

According to a second aspect of the present invention, there is provided the copper-ceramic bonded substrate of the first aspect,
wherein the copper sheet is heated to 380°C, held for 10 minutes, and then cooled to 40°C, and this heat cycle is repeated 20 times, and then the copper sheet is allowed to cool to 20°C, with a result such that The Vickers hardness of the copper sheet after heat load is 50 HV or less.

According to a third aspect of the present invention, there is provided the copper-ceramic bonded substrate of the first or second aspect,
wherein a silver content in the copper sheet is 0.1 ppm to 20 ppm.

According to a fourth aspect of the present invention, there is provided the copper-ceramic bonded substrate of the third aspect,
wherein a total amount of impurity elements in the copper sheet, excluding magnesium, nickel, tin, selenium, tellurium, bismuth and silver, is 0.01 ppm to 12 ppm.

According to a fifth aspect of the present invention, there is provided the copper-ceramic bonded substrate of any one of the first to fourth aspects,
wherein a material of the copper sheet is oxygen-free copper or tough pitch copper.

According to a sixth aspect of the present invention, there is provided the copper-ceramic bonded substrate of any one of the first to fifth aspects, including:
a brazing bonded layer composed of a brazing material between the ceramic substrate and the copper sheet,
wherein the copper sheet is bonded to the ceramic substrate interposing the brazing bonded layer.

According to a seventh aspect of the present invention, there is provided a method for manufacturing a copper-ceramic bonded substrate, including:
placing a copper sheet on at least one surface of a ceramic substrate and heated to bond them together,
wherein the copper sheet has a magnesium content of 1 ppm or less, a nickel content of 2.5 ppm or less, a tin content of 0.05 ppm or less, a selenium content of 0.3 ppm or less, a tellurium content of 0.07 ppm or less, and a bismuth content of 0.2 ppm or less, and
in the bonding, the copper sheet is heated so that Vickers hardness of the copper sheet after bonding is 42.5 HV or less.

According to an eighth aspect of the present invention, there is provided the method of the seventh aspect,
wherein in the bonding, the copper sheet is placed on the ceramic substrate, and the ceramic substrate and the copper sheet are heated while being temporarily pressed against each other.

According to a nineth aspect of the present invention, there is provided the method of seventh or eighth aspect,
wherein a silver content in the copper sheet is 0.1 ppm to 20 ppm.

According to a tenth aspect of the present invention, there is provided the method of any one of the seventh to nineth aspects,
wherein a total amount of impurity elements in the copper sheet, excluding magnesium, nickel, tin, selenium, tellurium, bismuth and silver, is 0.01 ppm to 12 ppm.

According to an eleventh aspect of the present invention, there is provided the method of any one of the seventh to tenth aspects, wherein a material of the copper sheet is oxygen-free copper or tough pitch copper.

According to a twelfth aspect of the present invention, there is provided the method of any one of the seventh to eleventh aspects, wherein the copper sheet is placed on the ceramic substrate interposing a brazing material, and then heated to bond them together.

According to a thirteenth aspect of the present invention, there is provided the method of any one of the seventh to twelfth aspects, wherein in the bonding, heating is performed so that a holding time is 6 hours or more in a temperature range of 500°C or higher.

According to a fourteenth aspect of the present invention, there is provided the method of any one of the seventh to thirteenth aspects, wherein in the bonding, heating is performed so that a holding time is 2 hours or more in a temperature range of 700°C or higher.

According to a fifteenth aspect of the present invention, there is provided the method of any one of the seventh to fourteenth aspects, wherein a load pressure of the temporary press in the bonding is 0.5 kPa to 5 kPa.

### Advantage of the invention

According to the present invention, in a copper-ceramic bonding substrate, good heat cycle properties can be achieved without changing an outer size.

### Brief description of the drawings

FIG. 1 is a cross-sectional view that illustrates an example of a copper-ceramic bonded substrate according to one embodiment of the present invention.
FIG. 2 is a schematic view for explaining a shape of a circuit pattern formed on one surface of the bonded substrate of an example.
FIG. 3 is a schematic view for explaining a shape of a heat sink pattern formed on the other surface of the bonded substrate of the embodiment.

### Detailed description of the invention

### <Finding obtained by the present inventors>

First, the finding obtained by the present inventors will be described.

A copper sheet used in a copper-ceramic bonded substrate (hereinafter also simply referred to as a bonded substrate) is generally made of a plate material of pure copper with a copper purity of 99.9 mass % or more, such as oxygen-free copper (C1020) or tough pitch copper (C1100). However, it was found that even if the copper sheet of the same specification (same type of pure copper, same quality) was used, the heat cycle properties of a final copper-ceramic bonded substrate were different.

After examining and investigating this point, it was found that a difference in heat cycle properties was due to the Vickers hardness of the copper sheet in the copper-ceramic bonded substrate. The higher the Vickers hardness of the copper sheet, the more likely it was to undergo work hardening due to the heat load of the heat cycle, and the worse the heat cycle properties tended to be. Generally, when the copper sheet is bonded to the ceramic substrate, it is annealed at a temperature above the softening point of copper (e.g. 200°C), and therefore the strain accumulated in the copper sheet decreases, and the Vickers hardness decreases accordingly. However, even for the copper sheets of the same specifications, the amount of trace impurities contained in the cast copper cake before rolling, as well as the rolling conditions, heat treatment conditions, and other manufacturing conditions are considered to be different for each copper roll manufacturer, and a state of recovery, recrystallization, and grain growth of copper crystals during the bonding of the bonded substrates are also different. This is presumably related to the Vickers hardness of the copper sheet in a final bonded substrate and its heat cycle properties.

Therefore, the present inventors further investigated a relationship between the Vickers hardness of the copper sheets after bonding, the amount of trace impurity elements contained in the copper sheets, and the heat cycle properties of the bonded substrate.

As a result, it was found that high heat cycle properties could be obtained by adjusting the Vickers hardness of the copper sheet in the copper-ceramic bonded substrate to a predetermined value or less. In addition, it was also found that by controlling the content of specific impurity elements in the copper sheet within a certain range, the Vickers hardness of the copper sheet in the bonded substrate could be controlled to a small value.

The present invention has been made based on the above findings.

### <One embodiment of the present invention>

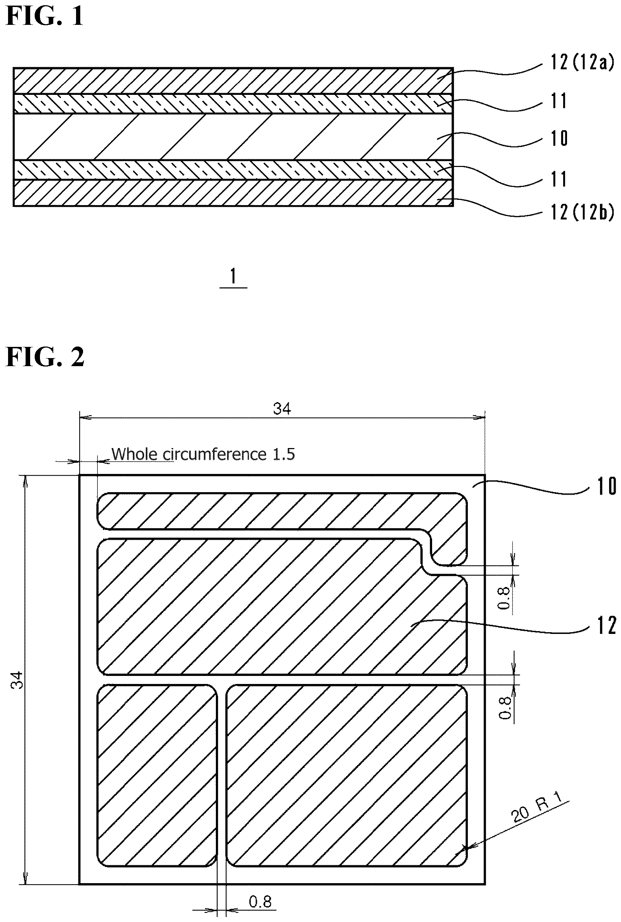

Hereinafter, preferable embodiments of a copper-ceramic bonded substrate according to the present invention will be described with reference to the drawings. FIG. 1 is a cross-sectional view that illustrates an example of a copper-ceramic bonded substrate according to one embodiment of the present invention. The present invention is not limited to these examples, but is defined by the claims, and is intended to include all modifications within the meaning and scope of the claims. Further, in this specification, a numerical range expressed using "to" means a range that includes the numerical values before and after "to" as lower and upper limits.

### (1) Copper-ceramic bonded substrate

First, a copper-ceramic bonded substrate will be described. Here, an example will be described in which copper sheets are bonded to both surfaces of a ceramic substrate. In this specification, the term "copper-ceramic bonded substrate" refers to both a substrate before a circuit pattern is formed on a copper sheet, and a circuit board after a circuit pattern is formed on a copper sheet. Hereinafter, the "copper-ceramic bonded substrate" may be simply referred to as a "bonded substrate."

As shown in FIG. 1, a copper-ceramic bonded substrate 1 (bonded substrate 1) of the present embodiment is configured to include, for example, a ceramic substrate 10, a brazing bonded layer 11, and a copper sheet 12. The bonded substrate 1 is processed into a copper-ceramic circuit board (hereinafter also referred to as a circuit board) by forming a predetermined pattern on the copper sheet 12.

### (Ceramic substrate)

The ceramic substrate 10 serves to support and fix the copper sheet 12, and further serves to provide insulation between circuits and between front and back sides when used as a circuit board. As the ceramic substrate 10, for example, an oxidebased ceramic substrate containing alumina, etc., as a main component, or a non-oxide-based ceramic substrate containing aluminum nitride, silicon nitride, silicon carbide, etc., as a main component can be used. The size of the ceramic substrate 10 is preferably 5 mm to 200 mm in length, 5 mm to 200 mm in width, and 0.2 mm to 3.0 mm in thickness, and more preferably, a substantially rectangular substrate having a length of 10 mm to 100 mm, a width of 10 mm to 100 mm, and a thickness of 0.25 mm to 2.0 mm can be used.

### (Brazing bonded layer)

A brazing bonded layer 11 is provided on both surfaces of the ceramic substrate 10. The brazing bonded layer 11 is interposed between the ceramic substrate 10 and the copper sheet 12 to bond them together. The brazing bonded layer 11 is formed from a brazing material that contains, for example, silver or copper as a metal component and further contains an active metal component (active metal-containing brazing material). The brazing bonded layer 11 is a layer formed by reaction between the components of the ceramic substrate 10, the brazing material, and the copper sheet 12 in a bonding described below.

The thickness of the brazing bonded layer 11 is not particularly limited, but from the viewpoint of ensuring a thermal shock resistance and bondability of the circuit board produced from the bonded substrate 1, it is preferably 3 µm to 50 µm, and more preferably 5 to 20 µm.

A silver content in the brazing material is not particularly limited, but from the viewpoint of improving the reliability of the bonding strength of the brazing bonded layer 11, it is preferably, for example, 30 to 95 mass %, more preferably 50 to 90 mass %, and even more preferably 65 to 90 mass %. The silver content in the brazing material indicates a mass ratio to a total mass of metal components contained in the brazing material. Hereinafter, the contents of metal components other than silver are also expressed as a ratio to a total mass of the metal components contained in the brazing material.

An active metal component preferably contains at least one active metal selected from, for example, titanium or zirconium. The content of the active metal component in the brazing material is, for example, preferably 1.0 to 7.0 mass %, and more preferably 1.5 to 6.5 mass %. This makes it possible to improve and ensure the bonding between the ceramic substrate and the copper sheet. When the active metal-containing brazing material is a silver-copper type, (remainder of) the metal components other than the above-described silver and active metal components is a copper content.

The brazing material may further contain tin as a metal component from the viewpoint of reducing a bond defect and suppressing migration. The tin content is preferably, for example, 10 mass % or less based on a total amount of metal elements. Tin can improve the bond between the ceramic substrate and the copper sheet. That is, in the case of silver-copper based active metal-containing brazing material, for example, as described above, the brazing material preferably has a silver content of 30 to 95 mass%, an active metal content of 1.0 to 7.0 mass%, a tin content of 10 mass% or less (preferably 1 to 8 mass%), with a remainder being copper.

### (Copper sheet)

Copper sheets 12 are bonded to both surfaces of the ceramic substrate 10 interposing brazing bonded layers 11. The copper sheet 12 is a plate-shaped member composed of pure copper containing copper and impurity elements. Of the two copper sheets 12, a copper sheet 12a bonded to one surface is used to form a predetermined circuit pattern. A copper sheet 12b bonded to the other surface is to form a heat sink pattern for releasing heat generated from chip components such as semiconductor elements mounted on the circuit pattern.

From the viewpoint of improving thermal conductivity and achieving high heat dissipation, the copper sheet 12 has a copper (Cu) content of 99.9 mass% or more, and is preferably pure copper with a Cu content of 99.96 mass% or more. Further, the copper sheet 12 contains impurity elements such as magnesium (Mg), nickel (Ni), selenium (Se), tin (Sn), tellurium (Te), bismuth (Bi), silicon (Si), iron (Fe), and silver (Ag).

### (Impurity elements in the copper sheet)

In the case of adding an element to copper, when the content of the element exceeds its solid solubility limit in copper, the element will form a precipitate in the copper. The precipitate hinders a slip motion of copper crystals or a movement or annihilation of dislocations when copper is heated, and is a factor that inhibits lowering the Vickers hardness caused with copper recrystallization. That is, the precipitate is a factor that increases the Vickers hardness of copper. Normally, when the copper sheet 12 is subjected to a heat load, the copper recrystallizes, thereby lowering the Vickers hardness of the copper sheet 12, but the precipitate inhibits the recrystallization of copper, so the Vickers hardness of the copper sheet 12 is not sufficiently lowered. In the copper-ceramic bonded substrate 1, the copper sheet 12 is repeatedly subjected to heat loads, which increases the thermal stress caused by the difference in thermal expansion between the copper sheet and the ceramics, and the work hardening of the copper sheet 12 progresses, resulting in increasing the Vickers hardness of the copper sheet 12, causing microcracks, etc., to occur in the ceramic substrate 10.

When the present inventors investigated impurity elements that tend to increase the Vickers hardness, it was found that Mg, Ni, Se, Sn, Te and Bi are elements that have a particularly large effect on increasing the Vickers hardness. Mg, Se, Sn, Te and Bi have a low solid solubility limit in copper and therefore tend to easily form precipitates in copper. Further, Ni tends to easily form precipitates together with elements that are inevitably mixed into copper.

Further investigation into the contents of these impurity elements revealed that the contents of the respective impurity elements are preferably set as follows. That is, it is preferable to control the Mg content to 1 ppm or less, the Ni content to 2.5 ppm or less, the Se content to 0.3 ppm or less, the Sn content to 0.05 ppm or less, the Te content to 0.07 ppm or less, and the Bi content to 0.2 ppm or less. By controlling the contents of these impurity elements, the generation of precipitates can be suppressed, the Vickers hardness of the copper sheet 12 can be lowered, and an increase in the Vickers hardness due to heat load can be suppressed. The copper sheet 12 having such a composition can suppress work hardening caused by heat loads such as heat cycles. That is, the heat cycle properties of the copper-ceramic bonded substrate 1 can be further improved. The proportion of impurity elements is expressed in "ppm by mass", but for convenience it is expressed as "ppm". Further, the contents of impurity elements are values measured by glow discharge mass spectrometry (GDMS) as shown in the examples described later.

The content of each impurity element will be described below.

From the viewpoint of lowering the Vickers hardness of the copper sheet 12 in the bonded substrate 1 and suppressing the increase in the Vickers hardness due to heat load, the Mg content is preferably 1 ppm or less, more preferably 0.5 ppm or less, and even more preferably 0.1 ppm or less. Further, there is no particular lower limit for the Mg content, but a lower limit may be 0 ppm (no Mg is contained) or 0.01 ppm.

From the viewpoint of lowering the Vickers hardness of the copper sheet 12 in the bonded substrate 1 and suppressing an increase in the Vickers hardness due to a heat load, the Ni content is preferably 2.5 ppm or less, more preferably from 0.01 ppm to 2 ppm, and even more preferably from 0.1 ppm to 1.8 ppm.

From the viewpoint of lowering the Vickers hardness of the copper sheet 12 in the bonded substrate 1 and suppressing the increase in the Vickers hardness due to heat load, the Se content is preferably 0.3 ppm or less, more preferably 0.005 ppm to 0.2 ppm, and even more preferably 0.01 ppm to 0.1 ppm.

From the viewpoint of lowering the Vickers hardness of the copper sheet 12 in the bonded substrate 1 and suppressing the increase in the Vickers hardness due to heat load, the Sn content is preferably 0.05 ppm or less, more preferably 0.005 ppm to 0.05 ppm, and even more preferably 0.01 ppm to 0.05 ppm.

From the viewpoint of lowering the Vickers hardness of the copper sheet 12 in the bonded substrate 1 and suppressing the increase in the Vickers hardness due to heat load, the Te content is preferably 0.07 ppm or less, and more preferably 0.05 ppm or less. Further, there is no particular lower limit for the Tellurium content, but a lower limit may be 0 ppm (no Tellurium contained) or 0.01 ppm.

From the viewpoint of reducing the Vickers hardness of the copper sheet 12 in the bonded substrate 1 and suppressing the increase in the Vickers hardness due to heat load, the Bi content is preferably 0.2 ppm or less, more preferably 0.005 ppm to 0.1 ppm, and even more preferably 0.01 ppm to 0.08 ppm.

The copper sheet 12 may contain Ag in addition to Mg, Ni, Se, Sn, Te and Bi. Ag does not have a significant effect on the increase in the Vickers hardness of the copper sheet 12 and is therefore considered to be negligible. Therefore, the Ag content is preferably 20 ppm or less, more preferably 0.1 ppm to 15 ppm, and even more preferably 1 to 10 ppm.

Further, the copper sheet 12 may contain impurity elements other than the above-described Mg, Ni, Se, Sn, Te, Bi, and Ag. A total content of other impurity elements is preferably 0.01 ppm to 12 ppm, more preferably 0.1 ppm to 11 ppm, and most preferably 1 ppm to 11 ppm.

### (Vickers hardness)

The copper sheet 12 bonded to the ceramic substrate 10 has the content of impurity elements controlled within the above-described range and is configured with few precipitates, and therefore the Vickers hardness in the initial state after bonding is 42.5 HV or less. Further, the copper sheet 12 experiences a small increase in the Vickers hardness when subjected to heat load such as a heat cycle, and maintains a small Vickers hardness after repeated heat loads. Specifically, the copper sheet 12 is heated to 380°C at an average heating rate of 1.0°C/s, held at that temperature for 10 minutes, then rapidly cooled to 100°C at an average cooling rate of 2.5°C/s, and gradually cooled to 40°C at an average cooling rate of 0.5°C/s. This heat cycle is repeated 20 times and then the copper sheet 12 is allowed to cool to room temperature (20°C). At this time, the Vickers hardness of the copper sheet 12 after heat load is 50 HV or less. A lower limit of the Vickers hardness is not particularly limited, but is 30 HV or more in the initial state after bonding, and 40 HV or more after a predetermined heat load is applied.

The Vickers hardness is obtained by measuring the surface of the copper sheet 12 based on "JIS Z 2244 Vickers hardness test and a test method". A test force was 0.25 kgf and a holding time was 5 seconds. In JIS, the Vickers hardness unit HV is followed by the test force and holding time (for example, [HV0.25/5]), but in this specification, this is omitted and it is simply written as [HV].

Two copper sheets 12 used in the bonded substrate 1 may have the same composition or different compositions, but from the viewpoint of manufacturing efficiency, it is preferable that they have the same composition.

### (2) Method for manufacturing a copper-ceramic bonded substrate

Next, a method for manufacturing the above-described bonded substrate 1 will be described.

### (Preparation step)

First, the ceramic substrate 10, a raw copper sheet, and a brazing material are prepared.

As a raw copper sheet, for example, an oxygen-free copper sheet can be used, and it is advisable to appropriately select one whose Mg, Ni, Se, Sn, Te and Bi contents are within the above-described ranges. The Vickers hardness of the raw copper sheet is not particularly limited, but is preferably, for example, 120 HV or less, and more preferably within a range of 50 HV to 120 HV.

The active metal-containing brazing material may be in the form of a paste or foil. The paste-like brazing material can be produced by a known method of kneading a metal powder composed of a metal component with a vehicle containing a binder and a solvent. As described above, the brazing material contains, for example, silver and copper as metal components, and preferably contains at least one active metal selected from titanium or zirconium, and may contain at least one metal component selected from tin or indium.

### (Brazing layer forming step)

Next, a brazing material in a paste form, for example, is applied to both surfaces of the ceramic substrate 10. Then, the applied brazing material is dried in the air or in an inert atmosphere to form a brazing material layer. The brazing material can be applied by a conventional method such as screen printing, spraying, or using a roll coater. When the brazing material is a foil, the brazing material layer may be formed by placing the brazing material foil in contact with the surface of the ceramic substrate.

### (Copper sheet bonding)

Next, a raw copper sheet is placed in contact with the brazing material layer, and a temporary pressing is applied to the raw copper sheet to prevent misalignment of the raw copper sheet, and then the stack is heated in a vacuum or a non-oxidizing atmosphere. Thereby, the brazing material layer melts and bonds the raw copper sheet and the ceramic substrate 10 to form a brazing bonded layer 11, and the raw copper sheet is bonded to the ceramic substrate 10 interposing the brazing bonded layer 11. During bonding, the raw copper sheets are annealed by heating, and Cu is recrystallized to reduce dislocations remaining inside, thereby forming the copper sheet 12 having a predetermined Vickers hardness. In the present embodiment, by setting the impurity elements contained in the copper sheet 12 to the above-described predetermined content, the Vickers hardness of the copper sheet 12 can be set to 42.5 HV or less. Further, with such a copper sheet 12, the Vickers hardness can be 50 HV or less after the above-described predetermined heat load is repeatedly applied.

The term "placing the raw copper sheet in contact with the brazing material layer" refers to stacking the ceramic substrate 10 and the raw copper sheet with the brazing material layer interposed therebetween. The term "temporarily pressing the raw copper sheet" refers to placing a weight on the raw copper sheet in this stack interposing a spacer such as a ceramic substrate, or applying pressure using a jig that clamps the stack, to prevent the raw copper sheet from misalignment, etc. The term "temporary pressing" refers to a low pressing load that can suppress the misalignment of the raw copper sheets and a low pressing load applied so as not to excessively increase the Vickers hardness of the copper sheet 12 obtained by bonding. When the pressing load during bonding is excessively high, the copper sheet 12 may be deformed by the bonding load during a cooling step after bonding, resulting in increase of the Vickers hardness due to the progress of work hardening. Therefore, from the viewpoint of setting the Vickers hardness of the copper sheet 12 after bonding within the above range, it is preferable to apply temporary pressing with a low pressing load. Specifically, the pressing load is preferably 0.5 kPa to 5 kPa.

Regarding the heating conditions during bonding, a temperature profile may be adjusted appropriately so that the Vickers hardness of the copper sheet 12 after bonding is 42.5 HV or less. That is, the time for which the temperature is held at or above a softening temperature of Cu (about 200°C) may be appropriately adjusted so that the Vickers hardness falls within a predetermined range. From the viewpoint of shortening the heating time and improving the manufacturing efficiency, it is preferable to perform heating so that the holding time is 6 hours or longer in a temperature range of 500°C or higher (at least twice the softening temperature of Cu), or it is more preferable to perform heating so that the holding time is 2 hours or longer in a temperature range of 700°C or higher. In the brazing method, the bonding temperature at which the brazing material melts and bonds the raw copper sheet and the ceramic substrate 10 is generally 750°C or higher, preferably 770°C or higher, and it is preferable to control the temperature profile so as to satisfy the above-described temperature range and holding time.

As described above, the bonded substrate 1 is obtained in which the copper sheet 12 is bonded to the surface of a ceramic substrate 10 interposing the brazing bonded layer 11.

### (3) Copper-ceramic circuit board and its manufacturing method

Next, a method for producing a circuit board from the above-described bonded substrate 1 will be described.

First, for example, a resist film for etching having a predetermined circuit pattern is formed on the surface of the copper sheet 12a of the bonded substrate 1. Further, a resist film for etching having a predetermined heat sink pattern is formed on the surface of the copper sheet 12b. These resist films may be formed on the surfaces of the copper sheets 12a and 12b by forming a resist by a known method such as screen printing, laminating, or photomasking, and then curing it.

Next, a known etching solution, such as cupric chloride, ferric chloride, hydrofluoric acid, or a chelating agent, is used to remove areas of the copper sheet 12 and the brazing bonded layer 11 (a layer formed by reaction of the brazing material with the copper sheet and the ceramic substrate in the copper sheet bonding) that are not covered with the resist film, thereby forming a predetermined circuit pattern and heat sink pattern.

Next, the circuit pattern and the heat sink pattern may be subjected to a plating process. As the plating process, for example, electroless Ni-P plating or electric Ni plating can be used.

In this manner, a circuit board is obtained.

### (4) Effect of the present embodiment

According to the present embodiment, one or more of the following effects are achieved.

The copper sheet 12 of the bonded substrate 1 of the present embodiment contains predetermined amounts of the impurity elements Mg, Ni, Se, Sn, Te and Bi, and preferably has a Vickers hardness of 42.5 HV or less in the initial state after bonding, and a Vickers hardness of 50 HV or less after repeated application of a predetermined heat load. Such a copper sheet 12 has few dislocations, and therefore Cu crystals can easily take a slip motion when heated, and work hardening due to thermal deformation can be suppressed. That is, the copper sheet 12 can reduce the Vickers hardness in the initial state and reduce the increase in Vickers hardness due to heat load. Therefore, for example, when a power module is fabricated by mounting a semiconductor chip on a circuit board obtained from the bonded substrate 1, work hardening of the circuit pattern and the like due to heat load such as furnace processing during a fabrication process can be suppressed. This makes it possible to suppress an increase in the thermal stress applied to the ceramic substrate 10, reduce damage accumulated in the ceramic substrate 10 during the fabrication process, and suppress microcracks occurring in the ceramic substrate 10. In addition, during use, although the power modules are subjected to a heat load caused by the heat cycle such as generating heat when the semiconductor chips are switched on and are cooled when the chips are turned off, damage to the ceramic substrate 10 can also be reduced even in this heat cycle. In this manner, according to the bonded substrate 1 of the present embodiment, damage caused by repeated heat loads can be reduced, and high heat cycle resistance can be achieved.

Further, according to the bonded substrate 1 of the present embodiment, because of its high heat cycle resistance, it is possible to omit providing a stepped or dimpled shape in a metal portion in order to relieve the thermal stress applied to the ceramic substrate of the circuit board. Therefore, it is possible to avoid an increase in an external size of the bonded substrate 1 while ensuring a mounting area for mounting a semiconductor chip on the surface of the circuit board. Further, the manufacturing steps of forming a stepped shape or a dimple shape can be omitted, in which case a manufacturing cost can be reduced.

Further, in producing the bonded substrate 1 of the present embodiment, a raw copper sheet having contents of Mg, Ni, Se, Sn, Te and Bi within predetermined ranges is used. In this raw copper sheet, the impurity elements that have a low solid solubility limit in copper and form precipitates to increase the Vickers hardness of the copper sheet 12, are controlled to a predetermined content. Therefore, an increase in the Vickers hardness of the copper sheet 12 can be suppressed. Therefore, during bonding, the slip motion of Cu crystals is promoted, and the Vickers hardness of the copper sheet 12 can be set within the above range.

Further, in the present embodiment, the ceramic substrate 10 and the raw copper sheet are bonded (brazed) interposing the brazing material. By using brazing, the heating temperature during bonding can be lowered compared to when the ceramic substrate 10 and the raw copper sheet are directly bonded to each other, and the bonding reliability of the copper sheet 12 with the ceramic substrate 10 can be maintained at a high level. Further, in the case of direct bonding, the heating temperature during bonding is relatively high, and the Vickers hardness tends to be reduced more easily by recrystallization. However, according to the present embodiment, since the raw copper sheet contains a small amount of impurities, recrystallization is easy and the Vickers hardness of the copper sheet 12 can be reduced. That is, in the bonded substrate 1 of the present embodiment, the Vickers hardness of the copper sheet 12 can be reduced while increasing the bonding reliability of the copper sheet 12.

Further, in the present embodiment, the ceramic substrate 10 and the raw copper sheet are bonded in an arranged state or in a state where they are temporarily pressed after being arranged. By bonding in this state, a bonding load applied to the copper sheet 12 can be reduced. This makes it possible to suppress deformation of the copper sheet 12 due to the bonding load, and to suppress the increase in the Vickers hardness due to deformation.

### <Other embodiments of the present invention>

The embodiments of the present invention have been specifically described above, but the present invention is not limited to the above-described embodiment, and various modifications can be made without departing from the gist of the present invention.

For example, the above-described embodiment shows the case where the copper sheets 12 are bonded to both surfaces (upper and lower surfaces) of the ceramic substrate 10, but in the copper-ceramic bonded substrate 1, it is sufficient that the copper sheet 12 is bonded to at least one surface of the ceramic substrate 10.

Further, for example, although the mounting area is reduced, in order to further reduce the thermal stress on the ceramic substrate 10 due to heat load, a stepped shape may be provided in the cross-sectional shape of the copper sheet of the circuit board, or a dimple shape may be provided on the outer periphery of the metal portion.

Further, the above-described embodiment shows the case where the ceramic substrate 10 and the copper sheet 12 are bonded interposing the brazing material, but the present invention is not limited thereto. For example, the ceramic substrate 10 and the copper sheet 12 may be directly bonded to each other. In this case, for example, the ceramic substrate 10 and the copper sheet 12 may be placed in contact with each other without interposing the brazing material, and then heated in an inert gas atmosphere to bond them together. The heating temperature at this time may be, for example, 1065°C or higher and 1083°C or lower. Further, the heating time is not particularly limited as long as the bonding reliability between the ceramic substrate 10 and the copper sheet 12 can be ensured.

### Examples

Next, the present invention will be described in more detail based on examples, but the present invention is not limited to these examples.

### <Samples 1 to 5>

In this example, a bonded substrate was produced and its heat cycle properties were evaluated.

First, in order to produce the bonded substrate, a ceramic substrate, a raw copper sheet, and a brazing material were prepared.

As the ceramic substrate, an AlN ceramic substrate was prepared. The AlN substrate has dimensions of 68 mm length × 68 mm width × 0.64 mm thickness, and is provided with dividing lines so that it can be divided into four individual pieces each having dimensions of 34 mm length × 34 mm width × 0.64 mm thickness.

As the raw copper sheet, an oxygen-free copper sheet (size 68 mm×68 mm×0.25 mm) having a copper purity of 99.96 mass % or more and an alloy number and quality classification of C1020-1/2H was prepared. In this example, as shown in Table 1, five types of oxygen-free copper sheets, copper sheet A to copper sheet E, were prepared.

**[Table 1]**

| | Raw copper sheet | | | | | | | | |
|---|---|---|---|---|---|---|---|---|---|
| | Type | Impurity element content [ppm] | | | | | | | |
| | | Mg | Ni | Se | Sn | Te | Bi | Ag | Total amount of other impurity elements |
| Sample 1 | Copper sheet A | <0.01 | 0.20 | 0.04 | 0.04 | 0.01 | 0.02 | 8.8 | 4.7 |
| Sample 2 | Copper sheet B | <0.01 | 0.18 | 0.05 | 0.03 | <0.01 | 0.02 | 8.7 | 5.1 |
| Sample 3 | Copper sheet C | 0.02 | 1.7 | 0.09 | 0.02 | 0.03 | 0.04 | 9.2 | 10.7 |
| Sample 4 | Copper sheet D | 2.2 | 3.9 | 0.53 | 0.07 | 0.11 | 0.37 | 6.2 | 14.0 |
| Sample 5 | Copper sheet E | 1.8 | 3.6 | 0.37 | 0.13 | 0.10 | 0.46 | 6.9 | 12.9 |

In Table 1, the content of impurity elements in each of the copper sheets A to E was measured by glow discharge mass spectrometry (GDMS). Specifically, first, a sample piece of about 25 mm square was cut out from each raw copper sheet. Next, the sample piece was washed with nitric acid to remove surface contamination. The content of impurity elements in the cleaned sample piece was measured using a GDMS measuring device (VG9000 manufactured by VG Elemental). In Table 1, "Total amount of other impurity elements" indicates a total amount including elements other than those listed in the table. The measured values in Table 1 are obtained by a GDMS method, so "other impurity elements" does not include H, C, N, O, group 18 elements, and Ta which is a sample holder for the GDMS measurement device, which cannot be quantitatively evaluated by the GDMS method.

Measurement conditions for the GDMS method were set as follows. A flat cell for a planar sample was used as a discharge cell (ion source), and the discharge cell was cooled with liquid nitrogen during analysis. As a discharge gas, 6N grade high purity Ar gas was used, a glow discharge was in a constant current control mode of 3 mA, and a discharge voltage was controlled to 1 kV by an amount of the discharge gas to be introduced. For detection and measurement of an ion current, a Faraday detector was used for a matrix element Cu, and a Daly detector was used for the other impurity elements. The integration time of the detector was 160 ms acquisition time x 1 acquisition number for the Faraday detector, and 200 ms acquisition time x 3 to 5 times for the Daly detector. A mass resolution (m/Δm: 5% peak height) was adjusted to about 4000 or more. A built-in value was used for a relative sensitivity factor (RSF) for converting an ion current intensity ratio to a concentration. The ion current value used in the quantitative analysis is measured after surface contamination has disappeared through preliminary discharge (about 20 min) and the ion intensity ratio of each element has become stable. Further, in Table 1, less than 0.01 ppm (<0.01) means that the content is less than a lower measurement limit by the GDMS method and is an extremely small amount or zero.

The brazing material was produced as follows. 100 parts by mass of powder consisting of 10% by mass of copper powder, 1.7% by mass of titanium powder, 0.5% by mass of titanium oxide powder (titanium(IV) oxide rutile type), with a remainder being silver powder, were weighed, and to 100 parts by mass of these powders, 13.8 parts by mass of a vehicle consisting of an acrylic binder and a solvent was added, and a mixture was kneaded using a mortar and a three-roll mill to produce a paste-like brazing material.

Next, a copper-ceramic bonded substrate was produced using the prepared materials.

Specifically, first, a paste-like brazing material was applied to both surfaces of an AlN ceramic substrate. At this time, on the AlN ceramic substrate, the paste-like brazing material was screen-printed to a thickness of about 20 µm over substantially an entire surface of each of the four sections separated by parting lines. The AlN ceramic substrate to which the brazing material was applied was dried in the air to form a brazing material coated layer.

Next, copper sheets A to E are stacked on both surfaces of the AlN ceramic substrate by contacting them with each other interposing the brazing material coated layer, and a weight was placed on the stack interposing a ceramic substrate (alumina substrate) spacer to apply a pressure of 1 kPa to the stack, and in this state, the stack was then introduced into a vacuum furnace. The stack was heated in the vacuum furnace at a bonding temperature (maximum temperature) of 835°C for 40 minutes and then cooled. In the series of processes of increasing the temperature, maintaining the bonding temperature, and decreasing the temperature, the temperature range of 500°C or higher continued for 7.5 hours. Further, similarly, in the series of processes of increasing the temperature, maintaining the bonding temperature, and decreasing the temperature, the temperature range of 700° C. or higher continued for 2.5 hours. In this way, copper sheets A to E were bonded to the AlN ceramic substrate, and copper-ceramic bonded substrates were produced as samples 1 to 5.

### (Production of a circuit board)

Next, a circuit pattern and a heat sink pattern were formed on the copper-ceramic bonded substrate.

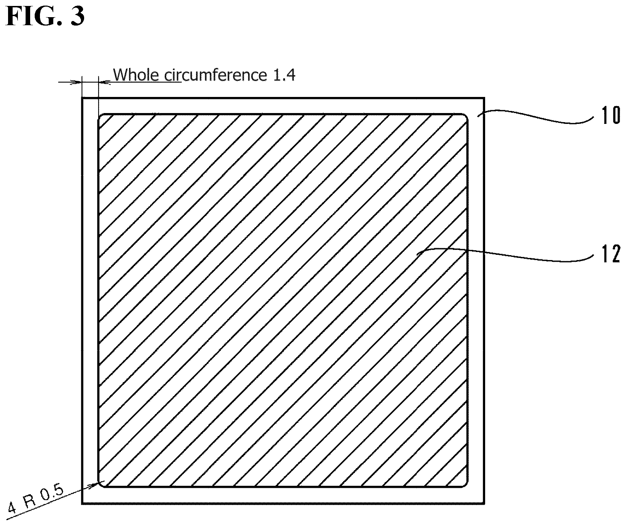

Specifically, an etching mask having a circuit pattern shape was formed on the surface of the copper sheet on one surface of the bonded substrate of samples 1 to 6, and an etching mask having a heat sink pattern shape was formed on the surface of the copper sheet on the other side by applying an ultraviolet-curable alkali-peelable resist ink by a screen printing method and curing it with ultraviolet light.
Thereafter, unnecessary parts of the copper sheet and the brazing bonded layer (parts not covered with the etching mask) were removed with a chemical solution, and then the etching mask was removed with an alkaline chemical solution. Then, the stack on which the circuit pattern and the heat sink pattern were formed was divided into four pieces along dividing lines provided on the AlN ceramic substrate. Thereby, a copper-ceramic bonding substrate (size 34 mm×34 mm) having a predetermined circuit pattern was produced. The circuit pattern shape and heat sink pattern shape of this circuit board (metal-ceramic bonded board) are shown in FIG. 2 and FIG. 3. FIG. 2 is a schematic view for explaining the shape of a circuit pattern formed on one surface of the bonded substrate of an example. FIG. 3 is a schematic view for explaining the shape of a heat sink pattern formed on the other surface of the bonded substrate of an example. (In this embodiment, the copper sheet of the bonded substrate is not plated.)

### (Evaluation method)

The Vickers hardness before bonding of the raw copper sheets, copper sheets A to E, and the Vickers hardness in the initial state after bonding of the copper sheets, the Vickers hardness after heat load, and the furnace pass durability were measured and evaluated for the circuit boards obtained from the bonded substrates of samples 1 to 5. The furnace pass durability was measured by an acceleration test to evaluate the effect of heating when assembling a power module using a circuit board, which is a heat treatment (heat cycle properties) acceleration test that simulates the case where a circuit board is passed through a furnace during assembly. Each measurement method is explained below.

### (Vickers hardness)

The Vickers hardness was measured for the raw copper sheet, the copper sheet in the initial state of the bonded substrate obtained by bonding, and the copper sheet after heat load in which the bonded substrate was subjected to a predetermined number of heat cycles under conditions described below. Specifically, using a measuring machine ("HM-200A" manufactured by Mitutoyo Corporation), the Vickers hardness was measured at 10 arbitrary points on the surface of each copper sheet under the following conditions: test force: 0.25 kgf, test force loading time: 4 s, test force holding time: 5 s, and test force unloading time: 4 s. An average value was used as the evaluation index.

The copper sheets after heat load were obtained by introducing each of the bonded substrates (circuit boards) of samples 1 to 5 into a batch furnace equipped with a carbon hot plate inside and a water-cooled cooling plate on the underside facing the hot plate that can be switched between contact and non-contact by raising and lowering, and then subjecting the copper sheets to a heat cycle. Specifically, the bonded substrate was placed on the upper surface of a hot plate in a batch furnace, and was subjected to heat load by repeatedly passing through the furnace. A temperature profile for one heat load in the furnace is as follows: with the cooling plate not in contact with the hot plate, the hot plate was heated to a maximum temperature of 380°C at an average heating rate of 1.0°C/s, then the maximum temperature of 380°C was maintained for 10 minutes, and the cooling plate was then brought into contact with the hot plate to rapidly cool to room temperature (average cooling rate from 380°C to 100°C was 2.5°C/s, and average cooling rate from 100°C to 40°C was 0.5°C/s). This was counted as one treatment. The atmosphere in the batch furnace during the furnace treatment was a reducing atmosphere of hydrogen/nitrogen = 20/80 (volume %). In this example, after repeating the above-described furnace heat load 20 times, the copper sheet after the heat load was allowed to cool to room temperature of 20°C, and the Vickers hardness of the copper sheet after heat load was measured by the above-described method.

### (Furnace pass durability)

The furnace pass durability was evaluated by repeatedly applying the above-described furnace heat load to the (unplated) circuit boards of samples 1 to 5, inspecting the ceramic substrate of the circuit board with a microscope every three furnace heat loads, and recording the number of times when a crack was first found on the ceramic substrate as a furnace pass durability value of that piece. This furnace pass durability test was performed to 10 pieces of circuit boards, and a Weibull plot analysis was performed to the furnace pass durability test results to estimate the Weibull distribution of the furnace pass durability. The expected value of the Weibull distribution was calculated from the estimated Weibull distribution, and the result was obtained as an expected furnace endurance value.

### (Evaluation results)

Evaluation results are summarized in Table 2.

**[Table 2]**

| | Vickers hardness [Hv] | | | Furnace pass durability [times] |
|---|---|---|---|---|
| | Raw copper sheet | Bonded substrate | | |
| | | Initial time | After heat load | |
| Sample 1 | 95.3 | 42.0 | 49.1 | 29.5 |
| Sample 2 | 96.4 | 41.7 | 48.9 | 34.8 |
| Sample 3 | 113.1 | 41.5 | 49.0 | 34.8 |
| Sample 4 | 109.0 | 43.1 | 50.6 | 25.0 |
| Sample 5 | 87.2 | 46.3 | 51.6 | 23.5 |

In samples 1 to 3, copper sheets A to D containing Mg, Ni, Sn, Se, Te and Bi within a specified range were used, and it was confirmed that when a bonded substrate is produced by bonding it to a ceramic substrate, the initial Vickers hardness of the copper sheet could be adjusted to 42.5 HV or less. This is presumably because, by controlling the impurity elements within a specified range, the generation of precipitates resulting from these elements is suppressed, and the heating during bonding promotes the slip motion of the copper crystals.

Further in samples 1 to 3, when the heat load was applied 20 times through the furnace, it was confirmed that the Vickers hardness after the heat load was 50 HV or less. That is, it was confirmed that the copper sheet was resistant to work hardening even when subjected to a certain heat cycle. This is presumably because, when subjected to heat cycle, the copper crystals easily take a slip motion due to heating, which suppresses work hardening due to thermal deformation.

Further, in samples 1 to 3, the Vickers hardness in the initial state was low and the increase in Vickers hardness due to heat cycles was small, and therefore the furnace pass durability was 28 times or more, and it was confirmed that the heat cycle properties were high.

In contrast, in samples 4 and 5, copper sheets D and E containing at least one of Mg, Ni, Sn, Se, Te and Bi in a greater than predetermined amount were used, and therefore it was confirmed that the Vickers hardness of the copper sheets in the initial state of the bonded substrate was greater than 42.5 HV. It was also confirmed that the Vickers hardness after heat load following repeated heat cycles was greater than 50 HV. These samples contained a large amount of certain impurity elements, which resulted in the generation of many precipitates. Therefore, it is considered that the slip motion of copper crystals was easily hindered when heated, causing the copper sheet to thermally deform and progress to work hardening. In these samples, the furnace pass durability was less than 28 times, and it was confirmed that the heat cycle properties were poor.

As described above, it is confirmed that by using a copper sheet containing Mg, Ni, Sn, Se, Te and Bi within a specified range in a bonded substrate, the Vickers hardness of the copper sheet in its initial state when bonded to a ceramic substrate can be lowered, and the increase in the Vickers hardness when subjected to repeated heat cycles can also be reduced.

### Description of signs and numerals

1. Copper-ceramic bonded substrate
10. Ceramic substrate
11. Brazing material bonded layer
12. Copper sheet

## Claims

1. A copper-ceramic bonded substrate, comprising:
a ceramic substrate; and
a copper sheet bonded to at least one surface of the ceramic substrate,
wherein the copper sheet has a Vickers hardness of 42.5 HV or less, and the copper sheet has a magnesium content of 1 ppm or less, a nickel content of 2.5 ppm or less, a tin content of 0.05 ppm or less, a selenium content of 0.3 ppm or less, a tellurium content of 0.07 ppm or less, and a bismuth content of 0.2 ppm or less.

2. The copper-ceramic bonded substrate according to claim 1,
wherein the copper sheet is heated to 380°C, held for 10 minutes, and then cooled to 40°C, and this heat cycle is repeated 20 times, and then the copper sheet is allowed to cool to 20°C, with a result such that The Vickers hardness of the copper sheet after heat load is 50 HV or less.

3. The copper-ceramic bonded substrate according to claim 1 or 2,
wherein a silver content in the copper sheet is 0.1 ppm to 20 ppm.

4. The copper-ceramic bonded substrate according to claim 3,
wherein a total amount of impurity elements in the copper sheet, excluding magnesium, nickel, tin, selenium, tellurium, bismuth and silver, is 0.01 ppm to 12 ppm.

5. The copper-ceramic bonded substrate according to any one of claims 1 to 4,
wherein a material of the copper sheet is oxygen-free copper or tough pitch copper.

6. The copper-ceramic bonded substrate according to any one of claims 1 to 5, comprising:
a brazing bonded layer composed of a brazing material between the ceramic substrate and the copper sheet,
wherein the copper sheet is bonded to the ceramic substrate interposing the brazing bonded layer.

7. A method for manufacturing a copper-ceramic bonded substrate, comprising:
placing a copper sheet on at least one surface of a ceramic substrate and heated to bond them together,
wherein the copper sheet has a magnesium content of 1 ppm or less, a nickel content of 2.5 ppm or less, a tin content of 0.05 ppm or less, a selenium content of 0.3 ppm or less, a tellurium content of 0.07 ppm or less, and a bismuth content of 0.2 ppm or less, and
in the bonding, the copper sheet is heated so that Vickers hardness of the copper sheet after bonding is 42.5 HV or less.

8. The method for manufacturing a copper-ceramic bonded substrate according to claim 7,
wherein in the bonding, the copper sheet is placed on the ceramic substrate, and the ceramic substrate and the copper sheet are heated while being temporarily pressed against each other.

9. The method for manufacturing a copper-ceramic bonded substrate according to claim 7 or 8,
wherein a silver content in the copper sheet is 0.1 ppm to 20 ppm.

10. The method for manufacturing a copper-ceramic bonded substrate according to any one of claims 7 to 9,
wherein a total amount of impurity elements in the copper sheet, excluding magnesium, nickel, tin, selenium, tellurium, bismuth and silver, is 0.01 ppm to 12 ppm.

11. The method for manufacturing a copper-ceramic bonded substrate according to any one of claims 7 to 10, wherein a material of the copper sheet is oxygen-free copper or tough pitch copper.

12. The method for manufacturing a copper-ceramic bonded substrate according to any one of claims 7 to 11, wherein the copper sheet is placed on the ceramic substrate interposing a brazing material, and then heated to bond them together.

13. The method for manufacturing a copper-ceramic bonded substrate according to any one of claims 7 to 12, wherein in the bonding, heating is performed so that a holding time is 6 hours or more in a temperature range of 500°C or higher.

14. The method for manufacturing a copper-ceramic bonded substrate according to any one of claims 7 to 13, wherein in the bonding, heating is performed so that a holding time is 2 hours or more in a temperature range of 700°C or higher.

15. The method for manufacturing a copper-ceramic bonded substrate according to any one of claims 7 to 14, wherein a load pressure of the temporary press in the bonding is 0.5 kPa to 5 kPa.
